# EUROPEAN PATENT APPLICATION

(11) **EP 4 760 130 A1**
(43) Date of publication of application: **17.06.2026**
(21) Application number: 24851359.0
(22) Date of filing: 23.05.2024
(51) Int. Cl.: F16K 3/18, F16K 51/02

(54) **GATE VALVE, GATE VALVE CONTROL MECHANISM AND CONTROL METHOD THEREFOR, AND SEMICONDUCTOR MANUFACTURING DEVICE**

(30) Priority: 09.08.2023 JP 2023130137
(71) Applicant: Kitz Sct Corporation, Tokyo 105-7305 (JP)
(72) Inventor: TAKEZAWA, Yuichi, Tokyo 143-0016 (JP); KITAMURA, Tsutomu, Tokyo 143-0016 (JP); OOYACHI, Kojiro, Ota-shi, Gunma 370-0352 (JP)
(74) Representative: Meissner Bolte Partnerschaft mbB
(86) International application number: PCT/JP2024/018956
(87) International publication number: WO 2025/032925

(57) **Abstract**

Provided is a technology that accelerates opening and closing of a gate valve while preventing generation of particles. A gate valve control mechanism (40) opens and closes a gate valve (41) by causing a disc (46) to move in an L-motion with one stroke by an air cylinder (50). A control section (43) controls a voltage applied to piezoelectric element valves (64-67) of a flow rate adjustment unit (42) so as to reduce an amount of air in the air cylinder (50) in a terminal part of the valve closing stroke by the air cylinder (50).

## Description

### Technical Field

The present invention relates to a gate valve, a gate valve control mechanism, a control method therefor, and a semiconductor manufacturing device.

### Background Art

In manufacture of wafers in semiconductor manufacturing devices, various processes, such as gas processes on the wafers, are carried out. In such manufacture of wafers, a processing section accommodates a wafer conveyed from a conveyance section, and the conveyance section and the processing section are blocked in an airtight manner. As a technology used to allow for communication and block between a conveyance section and a processing section as described above, a gate valve has been known that seats and separates a disc on and from a valve seat in an L-motion with use of a combination of an air cylinder and a cam mechanism (see Patent Literatures 1 and 2).

### Citation List

### [Patent Literature]

[Patent Literature 1]
   Japanese Patent Application Publication Tokukai No. 2020-56498
[Patent Literature 2]
   Japanese Patent Application Publication Tokukai No. 2021-71186

### Summary of Invention

### Technical Problem

From the viewpoint of increasing productivity of manufacture of semiconductors, it is required to accelerate opening and closing of a gate valve. On the other hand, if opening and closing of the gate valve is accelerated, foreign matters called particles may be mixed into an atmosphere in manufacture of a semiconductor upon closing of the gate valve, resulting in a lower yield of semiconductor products. As described above, the conventional technology has room for consideration from the viewpoint of accelerating opening and closing of the gate valve while preventing generation of the particles.

It is an object of an aspect of the present invention to provide a technology that accelerates opening and closing of a gate valve while preventing generation of particles.

### Solution to Problem

In order to solve the foregoing problem, a gate valve in accordance with an aspect of the present invention includes a fluid cylinder that seats and separates a disc on and from a valve seat, the gate valve being configured to cause the disc to move in an L-motion with one stroke by the fluid cylinder, an amount of a fluid in the fluid cylinder being controlled so as to enable deceleration of a speed of movement of the disc at least in a terminal part of the L-motion.

In order to solve the foregoing problem, a gate valve control mechanism in accordance with an aspect of the present invention includes: a gate valve including a fluid cylinder that seats and separates a disc on and from a valve seat, the gate valve being configured to cause the disc to move in an L-motion with one stroke by the fluid cylinder; a piezoelectric element valve or a polymeric actuator that controls an amount of a fluid in the fluid cylinder by opening and closing one or both of a supply flow path of a fluid to the fluid cylinder and a discharge flow path of a fluid from the fluid cylinder through application of a voltage; and a control section that controls a voltage applied to the piezoelectric element valve or the polymeric actuator so as to reduce an amount of the fluid in the fluid cylinder at least in a terminal part of a valve closing stroke by the fluid cylinder for seating the disc on the valve seat.

In order to solve the foregoing problem, a gate valve control method in accordance with an aspect of the present invention is a method for controlling the gate valve control mechanism, the method including controlling a voltage applied to the piezoelectric element valve or the polymeric actuator so as to reduce an amount of the fluid in the fluid cylinder when the fluid cylinder has reached at least the terminal part of the valve closing stroke by the fluid cylinder.

In order to solve the foregoing problem, a semiconductor manufacturing device in accordance with an aspect of the present invention includes: a conveyance section that conveys a wafer for a semiconductor product; a processing section that processes the wafer conveyed from the conveyance section; a gate valve that allows for communication and block between the conveyance section and the processing section; and a process control section that controls operations of the conveyance section, the processing section, and the gate valve to carry out a process on the wafer, the gate valve including a fluid cylinder that seats and separates a disc on and from a valve seat, the gate valve being configured to cause the disc to move in an L-motion with one stroke by the fluid cylinder, and an amount of a fluid in the fluid cylinder being controlled so as to enable deceleration of a speed of movement of the disc at least in a terminal part of the L-motion.

### Advantageous Effects of Invention

According to an aspect of the present invention, it is possible to provide a technology that accelerates opening and closing of a gate valve while preventing generation of particles.

### Brief Description of Drawings

Fig. 1 is a view schematically illustrating a structure of a semiconductor manufacturing device in accordance with an embodiment of the present invention.
Fig. 2 is a front view schematically illustrating a configuration of a gate valve control mechanism in accordance with an embodiment of the present invention in a valve open state.
Fig. 3 is a side view schematically illustrating a configuration of a gate valve of the gate valve control mechanism illustrated in Fig. 2 in a valve open state.
Fig. 4 is a view schematically illustrating a flow rate adjustment unit in an embodiment of the present invention.
Fig. 5 is a front view schematically illustrating a configuration of the gate valve illustrated in Fig. 2 midway in transitioning to a valve closed state.
Fig. 6 is a side view schematically illustrating a configuration of the gate valve illustrated in Fig. 5 midway in transitioning to a valve closed state.
Fig. 7 is a front view schematically illustrating a configuration of the gate valve illustrated in Fig. 2 in a valve closed state.
Fig. 8 is a side view schematically illustrating a configuration of the gate valve illustrated in Fig. 2 in a valve closed state.
Fig. 9 is a flowchart illustrating a flow of control of a gate valve in accordance with an embodiment of the present invention.
Fig. 10 is a view schematically illustrating changes in a travelling distance and movement speed of a disc in a valve closing stroke in a gate valve in accordance with an embodiment of the present invention.
Fig. 11 is a view schematically illustrating changes in a travelling distance and movement speed of a disc in a valve opening stroke in a gate valve in accordance with an embodiment of the present invention.
Fig. 12 is a view schematically illustrating a relationship between a movement speed of a disc and a particle generation amount in an L-motion in transitioning to a valve closed state in an embodiment of the present invention.

### Description of Embodiments

### [Semiconductor manufacturing device]

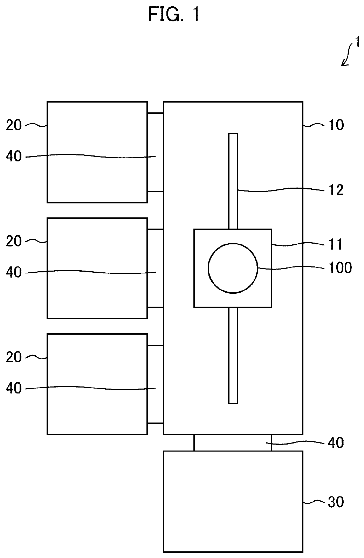

Fig. 1 is a view schematically illustrating a configuration of a semiconductor manufacturing device in accordance with the present embodiment. As illustrated in Fig. 1, a semiconductor manufacturing device 1 includes a conveyance section 10, processing sections 20, an accommodation section 30, and gate valve control mechanisms 40. The conveyance section 10, the processing sections 20, and the accommodation section 30 are each a chamber that is sealable in an airtight manner via the gate valve control mechanism 40.

The conveyance section 10 conveys a wafer 100 for a semiconductor product from the accommodation section 30 to a processing section 20, or between the processing sections 20. The conveyance section 10 includes a conveyance table 11 and a rail 12 for guiding the conveyance table 11 to the accommodation section 30 or the processing sections 20. The processing section 20 processes the wafer 100 conveyed from the conveyance section. For example, the processing sections 20 each carry out, on the wafer 100, a specific process set for each processing section 20, such as a surface treatment using gas. The accommodation section 30 accommodates an unprocessed wafer 100 to be conveyed to the processing section 20.

### [Gate valve control mechanism]

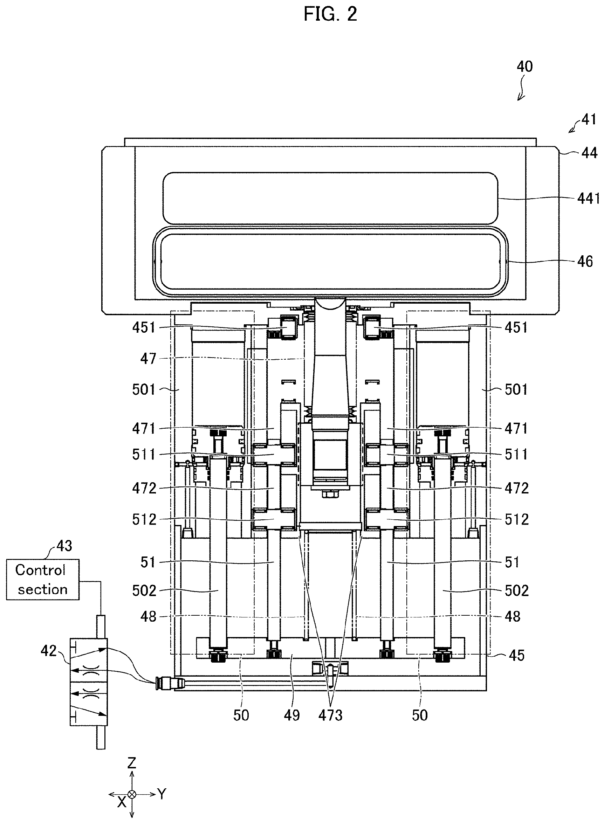

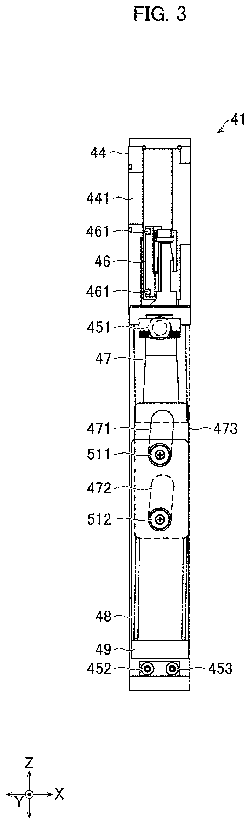

Fig. 2 is a front view schematically illustrating a configuration of a gate valve control mechanism in accordance with an embodiment of the present invention in a valve open state. Fig. 3 is a side view schematically illustrating a configuration of a gate valve of the gate valve control mechanism illustrated in Fig. 2 in a valve open state. Note that, in the present embodiment, an axial direction of an opening (slit 441) of the gate valve is referred to as an X direction, a width direction of the gate valve (long-side direction of the slit 441) is referred to as a Y direction, and a height direction of the gate valve (short-side direction of the slit 441) is referred to as a Z direction. As illustrated in Fig. 2, the gate valve control mechanism 40 includes a gate valve 41, a flow rate adjustment unit 42, and a control section 43.

### [Gate valve]

The gate valve 41 includes air cylinders that seat and separate the disc on and from a valve seat, and is configured to cause the disc to move in an L-motion with one stroke by the air cylinders. The "L-motion" means, as described in Patent Literatures 1 and 2, a motion in which in the vicinity of the valve seat, the disc moves closer to and away from the valve seat in a direction along an axis of the valve seat (e.g., along the axial direction or obliquely with respect to the axial direction), and in the other positions, the disc moves in a direction crossing the axis. That is, as for the "L-motion", a type that is raised and lowered obliquely with respect to the axial direction (an operation of moving in the Z direction while moving in the X direction) and a type that carries out a vertical movement and a horizontal movement with one stroke with use of a cam mechanism or the like without separating only one movement from them are widely used as valves for semiconductor manufacturing devices. In the present embodiment, the "L-motion" means a general term for these two types of motions, and means one or both of them.

As illustrated in Figs. 2 and 3, the gate valve 41 includes a drive section 45 for driving a disc 46 and a body 44 disposed in an upper part of the drive section 45 integrally with the drive section 45.

The body 44 has a substantially rectangular housing and has a slit 441. The slit 441 is an opening having a substantially rectangular opening shape with its long-side direction corresponding to the Y direction and with its short-side direction corresponding to the Z direction. The body 44 has one more slit opposite from the slit 441.

The drive section 45 includes a disc 46, a stem 47, a spring 48, and a base plate 49. The disc 46 is a rectangular plate-shaped member capable of sealing the slit 441 by abutting on the periphery (valve seat) of the slit 441 in the body 44. A sealing material 461 is provided around an outer edge part of the surface of the disc 46 which faces the slit 441. The stem 47 is a substantially bar-shaped member supporting the disc 46 at its tip end. The stem 47 is disposed so as to be movable in a Z direction and to be movable also in an X direction. The spring 48 has one end thereof connected to a base end of the stem 47 and the other end thereof connected to the base plate 49. The base plate 49 supports the stem 47 in the Z direction via the spring 48.

The drive section 45 further includes air cylinders 50 for causing the disc 46 to move. The two air cylinders 50 are disposed so as to sandwich the stem 47 and the spring 48 from both sides. The air cylinders 50 each include a cylinder tube 501 and a piston rod 502 slidable therein. To each of one end part and the other end part of the cylinder tube 501, a ventilation path of air from the flow rate adjustment unit 42 described later is connected. The piston rod 502 has a piston at its tip end, and its base end is connected to the base plate 49.

The drive section 45 further includes cam follower plates 51, cam rollers 511 and 512, cam grooves 471 and 472, and roller blocks 451. The cam follower plates 51 are each a member extending in a Z direction, and are supported at their base ends by the base plate 49. The cam rollers 511 and 512 are substantially cylindrical members protruding from the cam follower plates 51 toward the stem 47. The cam rollers 511 and 512 are fixed in two locations in a tip end part of each cam follower plate 51 so as to be aligned in the Z direction. The cam grooves 471 and 472 are formed on substrates 473 fixed to both side parts of the stem 47. The cam grooves 471 and 472 are positioned opposite from the cam rollers 511 and 512, and the cam roller 511 and the cam roller 512 engage respectively with the cam groove 471 and the cam groove 472 so as to be slidable therein. The cam grooves 471 and 472 are each a track-shaped groove when viewed in a plan view. A long axis of a shape of each of the cam grooves 471 and 472 when viewed in a plan view is inclined so as to be gradually located further away from the slit 441 in the X direction in a position closer to the body 44 in the Z direction. The roller blocks 451 are members disposed so as to protrude from the drive section 45. The roller blocks 451 are disposed in positions where the roller blocks 451 abut on the upper ends of the substrates 473 in a position where the disc 46 overlaps the slit 441 in the Z direction.

The drive section 45 further includes nozzles 452 and 453. The nozzle 452 is connected to a pipe that branches into two parts in the drive section 45, and is connected to one end part of each of the two air cylinders 50 via the pipe. Similarly, the nozzle 453 is also connected to a pipe that branches into two parts in the drive section 45. The nozzle 453 is connected to the other end part of each of the two air cylinders 50 via the pipe.

### [Flow rate adjustment unit]

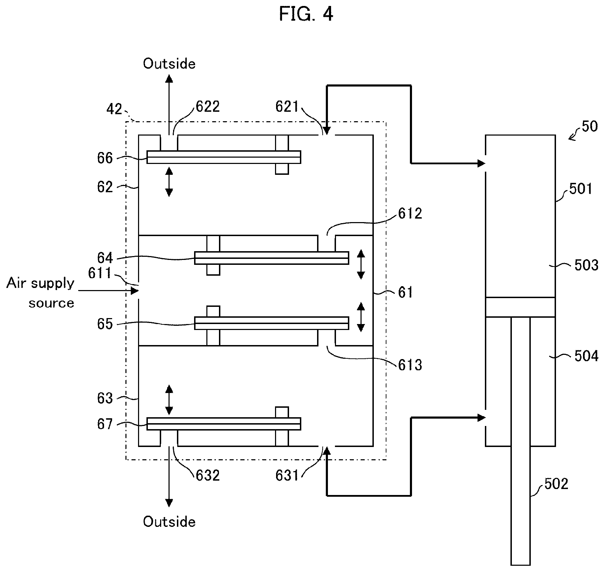

The flow rate adjustment unit 42 includes, for an air supply flow path and an air discharge flow path of each air cylinder 50, piezoelectric element valves that open and close in response to application of voltage, and is configured to adjust an amount of air in the air cylinder. Fig. 4 is a view schematically illustrating a flow rate adjustment unit 42 in the present embodiment. As illustrated in Fig. 4, the flow rate adjustment unit 42 includes a supply chamber 61 and communication chambers 62 and 63.

The supply chamber 61 has a supply opening 611 and communication openings 612 and 613. The supply opening 611 is connected to a supply source of air. The supply chamber 61 communicates with the communication chamber 62 via the communication opening 612, and communicates with the communication chamber 63 via the communication opening 613. In the supply chamber 61, a first piezoelectric element valve 64 capable of opening and closing the communication opening 612 and a first piezoelectric element valve 65 capable of opening and closing the communication opening 613 are disposed.

The communication chamber 62 has a ventilation opening 621 and an exhaust opening 622 in addition to the communication opening 612. The ventilation opening 621 communicates with a first chamber 503 on one end side in the cylinder tube 501 of the air cylinder 50 via a pipe. The first chamber 503 is a space on one end side with respect to a piston in the air cylinder 50. The exhaust opening 622 communicates with the outside of the flow rate adjustment unit 42. In the communication chamber 62, a second piezoelectric element valve 66 capable of opening and closing the exhaust opening 622 is disposed.

The communication chamber 63 has a ventilation opening 631 and an exhaust opening 632 in addition to the communication opening 613. The ventilation opening 631 communicates with a second chamber 504 on the other end side in the cylinder tube 501 of the air cylinder 50 via a pipe. The second chamber 504 is a space on the other end side with respect to the piston in the air cylinder 50. The exhaust opening 632 communicates with the outside of the flow rate adjustment unit 42. In the communication chamber 63, a second piezoelectric element valve 67 capable of opening and closing the exhaust opening 632 is disposed.

As described above, the flow rate adjustment unit 42 is configured to be capable of opening and closing air discharge flow paths from the air cylinders 50 with use of the piezoelectric element valves.

Note that in the present embodiment, each of the piezoelectric element valves has a laminated structure of a flexible substrate and a plate-shaped actuator made of piezoelectric ceramic. The piezoelectric element valve is fixed at one end part thereof, and is disposed such that the other end part thereof closes an opening such as a communication opening. Further, the flow rate adjustment unit 42 is configured to be capable of independently applying a voltage to each of the piezoelectric element valves.

By applying a voltage to the piezoelectric element valve, the actuator contracts, and the piezoelectric element valve warps, so that the opening is opened. When application of the voltage is stopped, the actuator returns to its original dimension, and the warp of the piezoelectric element valve is eliminated. As a result, the piezoelectric element valve is seated on the opening. From the viewpoint of enhancing sealing performance in the valve closed state, a seal member surrounding the opening may be provided around a portion of the piezoelectric element valve which faces the opening. Further, from the viewpoint of enhancing the sealing performance in the valve closed state, a spring member (such as a leaf spring) that abuts on the other end part of the piezoelectric element valve from a side opposite to the opening in a thickness direction of the piezoelectric element valve and that biases the piezoelectric element valve toward the opening may be further disposed in the flow rate adjustment unit 42.

### [Control section]

The control section 43 controls energization of the first piezoelectric element valves 64 and 65 and the second piezoelectric element valves 66 and 67 so that specific voltages are independently applied to the respective first piezoelectric element valves 64 and 65 and the second piezoelectric element valves 66 and 67. Here, of the strokes by each of the air cylinders 50, a stroke for seating the disc 46 on a valve seat (outer edge part of the slit 441) is referred to as "valve closing stroke", and a stroke for separating the disc 46 from the valve seat is referred to as "valve opening stroke". In the present embodiment, a stroke in which the air cylinder 50 contracts is the valve closing stroke, and a stroke in which the air cylinder 50 extends is the valve opening stroke. The control section 43 controls the voltages to be applied to the piezoelectric element valves described above so that an amount of a fluid in the air cylinder 50 becomes smaller in a terminal part of the valve closing stroke. The control section 43 is, for example, an integrated circuit that is disposed in the gate valve 41 and is capable of executing the control described above.

### [L-motion of gate valve]

With reference to Figs. 2, 3, and 5 to 8, the following will describe the L-motion of the gate valve 41 in the present embodiment.

### <Valve open state (Figs. 2 and 3)>

In a state where air is supplied to the first chambers 503 of the air cylinders 50 and air is exhausted from the second chambers 504 of the air cylinders 50, the air cylinders 50 extend, so that the piston rods 502 push the base plate 49 downward in the Z direction. Thus, the spring 48 and the cam follower plates 51 supported by the base plate 49 are located in a lowest possible position in the Z direction. Accordingly, the stem 47 supported by the spring 48 and the disc 46 supported by the stem 47 are also located in a lowest possible position in the Z direction, and are located in a position that does not overlap the slit 441 in the Z direction. The slit 441 is thus in an open state (a state in which the gate valve 41 is opened). In this state, the disc 46 and the stem 47 supporting the disc 46 are located in a position separated from a position of being seated on the slit 441 in the X direction by a distance in the X direction between both ends of the long axis of each of the cam grooves 471 and 472.

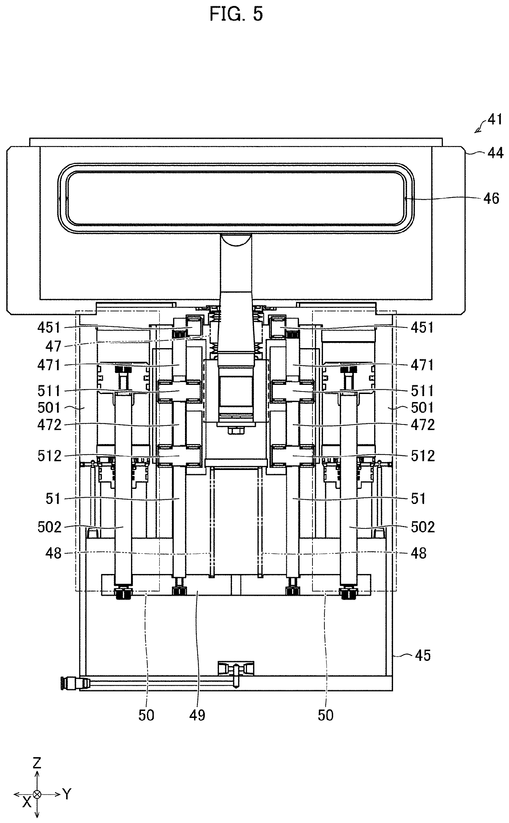

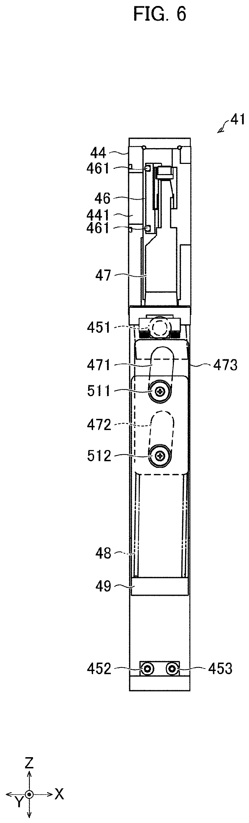

### <Movement in Z direction in L-motion (Figs. 5 and 6)>

Fig. 5 is a front view schematically illustrating a configuration of the gate valve 41 midway in transitioning to a valve closed state, and Fig. 6 is a side view thereof. When air is exhausted from the first chambers 503 of the air cylinders 50 and air is supplied to the second chambers 504 of the air cylinders 50, the air cylinders 50 contract, and the base plate 49 is raised in the Z direction. In accordance with the raising of the base plate 49, the cam follower plates 51 and the spring 48 are raised, and the stem 47 and the disc 46 are raised to a position where the disc 46 overlaps the slit 441 in the X direction. At this time, upper ends of the substrates 473 that have been raised in accordance with the raising of the stem 47 abut on the roller blocks 451. In the present embodiment, this timing (terminal time of the movement in the Z direction in the L-motion) is regarded as a terminal part of the valve closing stroke by the air cylinders 50.

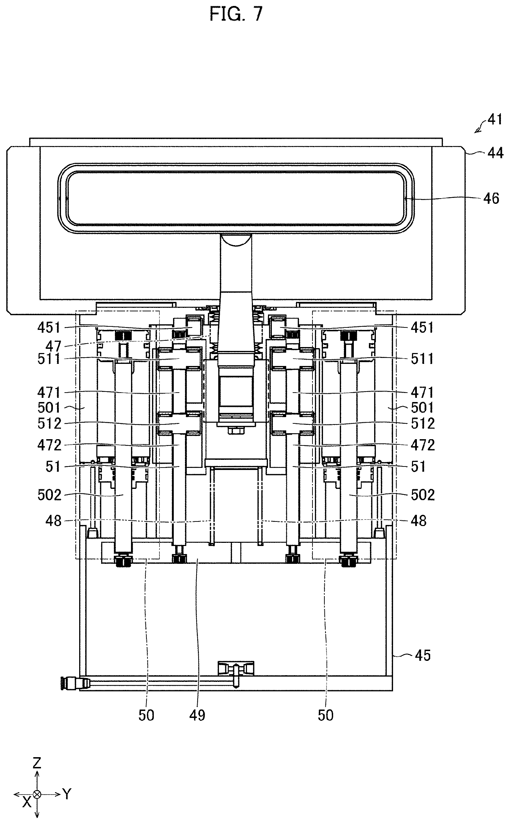

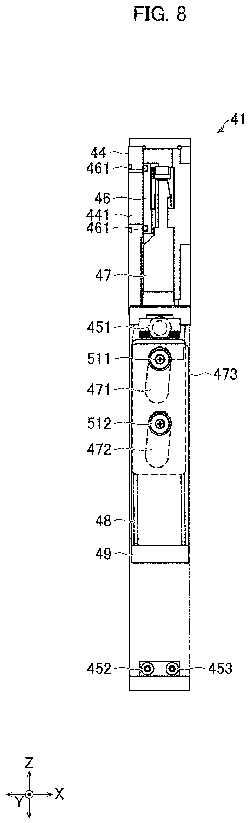

### <Movement in X direction in L-motion (Figs. 7 and 8)>

Fig. 7 is a front view schematically illustrating a configuration of the gate valve 41 in a valve closed state, and Fig. 8 is a side view thereof. When the air cylinders 50 further contract with the substrates 473 abutting on the roller blocks 451 in the Z direction, the base plate 49 is raised in the Z direction, thus further raising the cam follower plates 51 accordingly, and the stem 47 is restricted from moving (being raised) further in the Z direction. While further movement (raising) of the stem 47 in the Z direction is restricted, the spring 48 contracts in accordance with the raising of the base plate 49.

In accordance with the raising of the cam follower plates 51 in the Z direction, the cam rollers 511 and 512 move along a long axis of the cam grooves 471 and 472. As described above, the raising of the stem 47 in the Z direction is restricted, and the stem 47 is movable in the X direction. Therefore, movement of the cam rollers 511 and 512 in the cam grooves 471 and 472 causes the stem 47 to move toward the slit 441 side in the X direction by an amount corresponding to an inclination of the long axis of each of the cam grooves 471 and 472. Therefore, the disc 46 moves in the X direction and is seated on a periphery (valve seat) of the slit 441. In this way, the slit 441 is blocked by the disc 46, and the gate valve 41 is closed. In the present embodiment, this timing (terminal time of the movement in the X direction in the L-motion) is regarded as a terminal end of the valve closing stroke by the air cylinders 50.

### <Movement from closed valve to open valve>

When air is supplied to the first chambers 503 of the air cylinders 50 and air is exhausted from the second chambers 504 of the air cylinders 50, the air cylinders 50 extend, so that the base plate 49 is lowered in the Z direction. The stem 47 is biased upward in the Z direction by the contracting spring 48. Therefore, the cam rollers 511 and 512 slide in the cam grooves 471 and 472, and as a result, the disc 46 moves away from the slit 441 along the X direction. As the air cylinders 50 extend, the base plate 49 is further lowered in the Z direction, so that the substrates 473 move away from the roller blocks 451 in the Z direction. In this way, the gate valve 41 returns from the state illustrated in Figs. 7 and 8 to the state illustrated in Figs. 5 and 6, and as the air cylinders 50 further extend, the gate valve 41 is brought into the state illustrated in Figs. 2 and 3. As such, the gate valve 41 includes the air cylinders 50 that seat and separate the disc 46 on and from the valve seat, and is configured to cause the disc 46 to move in a reversible L-motion with one stroke by the air cylinders 50. Further, the stem 47 supports the disc 46 with use of the cam follower plates 51, the cam rollers 511 and 512, the roller blocks 451, and the cam grooves 471 and 472, and moves in coordination with the stroke by the air cylinders 50 in order from the Z direction to the X direction in transitioning to the valve closed state and in order from the X direction to the Z direction in transitioning to the valve open state.

### [Control method for gate valve]

### <Control example in transitioning to valve closed state>

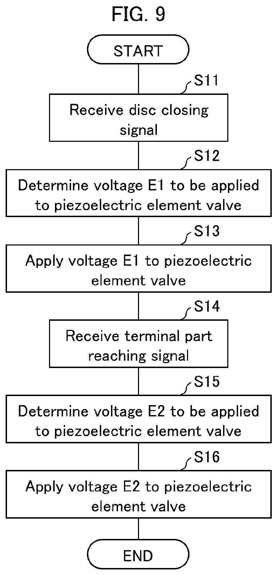

Fig. 9 is a flowchart illustrating a flow of control of a gate valve in accordance with the present embodiment. Fig. 9 illustrates an example of control in the case of closing the open gate valve 41.

In step S11, the control section 43 receives a signal to close the disc 46. The signal is transmitted, for example, from another control section that controls the semiconductor manufacturing device 1.

In step S12, the control section 43 determines a voltage value(s) E1 to be applied to a piezoelectric element valve(s) corresponding to a desired speed at which the disc 46 is caused to move in the Z direction. For example, the control section 43 refers to a map stored in advance to determine a piezoelectric element valve(s) for achieving a movement speed of the disc 46 corresponding to a processing speed in manufacture of a semiconductor, and a voltage value(s) to be applied at that time. The piezoelectric element valve(s) is, for example, the first piezoelectric element valve 65, and the voltage value(s) to be applied (voltage E1) is a voltage value for fully opening the first piezoelectric element valve 65.

In step S13, the control section 43 applies, to the piezoelectric element valve, a voltage having a voltage value E1 determined in step S12. For example, the control section 43 transmits, to a power source (not illustrated), a signal for causing the voltage E1 to be applied to the first piezoelectric element valve 65. This causes the air cylinders 50 to contract, so that the cam follower plates 51 approach the roller blocks 451 in the Z direction.

In step S14, the control section 43 receives a signal indicating that the valve closing stroke by the air cylinders 50 has reached its terminal part. The signal is, for example, a signal from a device (such as a position detection sensor or a contact switch) that detects contact of the cam follower plates 51 with the roller blocks 451.

In step S15, the control section 43 determines a voltage value(s) E2 to be applied to a piezoelectric element valve(s) corresponding to a desired speed at which the disc 46 is caused to move in the X direction. For example, the control section 43 refers to a map stored in advance to determine a piezoelectric element valve(s) for achieving a movement speed of the disc 46 at which generation of particles due to seating of the disc 46 on the valve seat is sufficiently suppressed, and a voltage value(s) to be applied at that time. The piezoelectric element valve(s) are, for example, the first piezoelectric element valve 65 and the second piezoelectric element valve 67, and the voltage value(s) (voltages E2) to be applied are a voltage value for fully opening the first piezoelectric element valve 65 and a voltage value for opening the second piezoelectric element valve 67 to an opening degree for deceleration to a desired speed.

In step S16, the control section 43 applies, to the piezoelectric element valves, voltages having voltage values E2 determined in step S15. For example, the control section 43 transmits, to the power source (not illustrated), a signal for causing the voltage E2 (in this case, same as the voltage E1) for fully opening the first piezoelectric element valve 65 to be applied to the first piezoelectric element valve 65, and transmits, to the power source, a signal for causing the voltage E2 for bringing the second piezoelectric element valve 67 to the opening degree corresponding to the deceleration described above to be applied to the second piezoelectric element valve 67.

Through the control as described above, the control section 43 causes the disc 46 to move fast in the Z direction in the L-motion, and causes the disc 46 to move sufficiently slowly only in the X direction in the L-motion. As a result, generation of particles at the time of seating of the disc 46 is prevented.

### <Control example in transitioning to valve open state>

Control of the gate valve 41 in transitioning to the valve open state can be carried out as in the control in transitioning to the valve closed state described above. For example, the control section 43 receives a signal to open the disc 46 and then refers to a map stored in advance to determine a piezoelectric element valve(s) for achieving a movement speed of the disc 46 corresponding to a processing speed of manufacture of a semiconductor, and a voltage value(s) to be applied at that time. Then, the control section 43 transmits, to the power source, a signal for causing a voltage(s) having the determined voltage value(s) to be applied to the determined piezoelectric element valve(s). Through such control, it is possible to quickly achieve opening of the gate valve 41 in accordance with the processing speed in manufacture of a semiconductor.

Alternatively, in the control of the gate valve 41 in transitioning to the valve open state, the applied voltage value may be changed at the stroke terminal part, similarly to the above-described control in transitioning to the valve closed state.

For example, the control section 43 receives a signal indicating that the valve opening stroke by the air cylinders 50 has reached its terminal part. In the signal, for example, a position about 10 mm above a lowest possible point of the base plate 49 in the valve opening stroke is set as a terminal part of the valve opening stroke, and it is detected that the base plate 49 has reached the position by a position detection sensor or proximity switch. Then, the control section 43 determines a voltage value(s) E3 to be applied to a piezoelectric element valve(s) corresponding to a desired speed at which the base plate 49 is appropriately decelerated in the Z direction. For example, the control section 43 determines, as the piezoelectric element valve(s), the first piezoelectric element valve 64 and the second piezoelectric element valve 66, determines, as the voltage value(s) E3 to be applied, a voltage value for fully opening the first piezoelectric element valve 64 and a voltage value for bringing the second piezoelectric element valve 66 to the opening degree corresponding to the deceleration described above, and transmits the determined voltage values to the power source.

Through the control described above, the control section 43 causes the disc 46 to move fast in the L-motion in transitioning to the valve open state, and decelerates the base plate 49 only in a terminal part of the valve opening stroke, thereby making it possible to sufficiently suppress occurrence of impact at the end point of the base plate 49 in transitioning to the valve open state.

### [Changes during movement of disc]

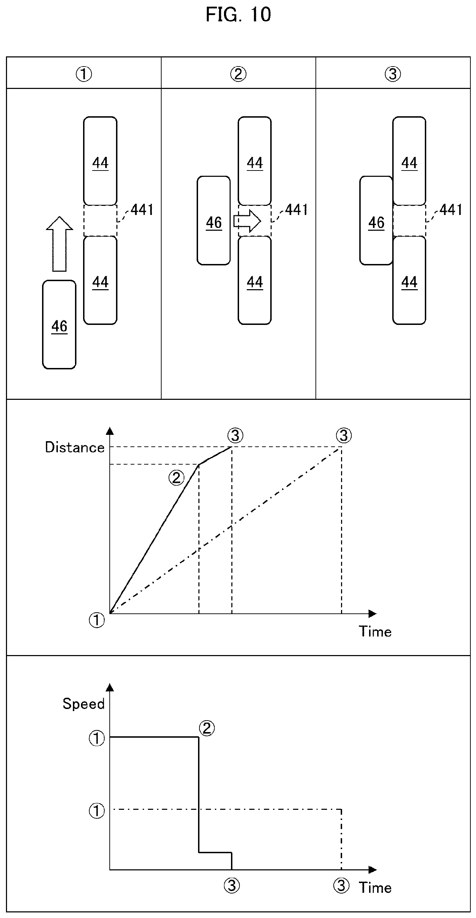

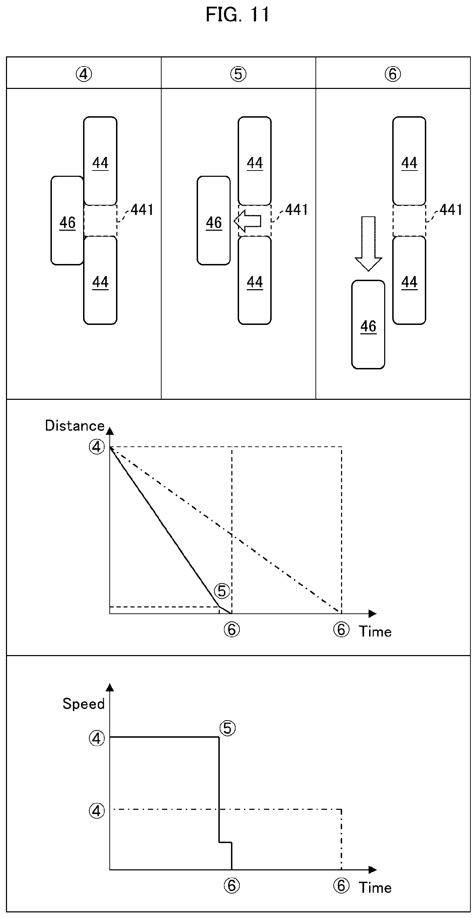

Fig. 10 is a view schematically illustrating changes in a travelling distance and movement speed of a disc in a valve closing stroke in a gate valve in accordance with the present embodiment. Fig. 11 is a view schematically illustrating changes in a travelling distance and movement speed of a disc in a valve opening stroke in a gate valve in accordance with the present embodiment. In the drawing, a solid line indicates an example of the present embodiment, and a dotted-and-dashed line indicates an example of a conventional configuration that employs an electromagnetic valve instead of the flow rate adjustment unit of the present embodiment. Further, in Fig. 10, the reference numeral "1" represents movement in the Z direction in the L-motion in transitioning to the valve closed state, the reference numeral "2" represents movement in the X direction in the L-motion in transitioning to the valve closed state, and the reference numeral "3" represents the end of the L-motion in transitioning to the valve closed state. Further, in Fig. 11, the reference numeral "4" represents movement in the X direction in the L-motion in transitioning to the valve open state, the reference numeral "5" represents movement in the Z direction in the L-motion in transitioning to the valve open state, and the reference numeral "6" represents the end of the L-motion in transitioning to the valve open state.

In the conventional configuration, the electromagnetic valve cannot adjust the speed of opening and closing during the L-motion, and thus the speed of opening and the closing is constant. Therefore, in the conventional configuration, in transitioning to the valve closed state, the disc is caused to move from beginning to end at the highest speed in a range in which generation of particles can be suppressed when the disc is seated on the valve seat. Similarly, in the conventional configuration, in transitioning to the valve open state, the disc is caused to move from beginning to end at the highest speed in a range in which an impact of collision between an operation part (for example, the base plate 49) and the drive section 45 at an end point of extension of the piston rod can be suppressed. As described above, in the conventional configuration, the disc moves at a constant speed determined at the terminal end of the L-motion.

In the present embodiment, in the other part (part from the start to the terminal part of the L-motion) than the terminal part of the L-motion, it is possible to freely set the movement speed of the disc in a range that can be achieved by operation of the air cylinders regardless of the speed at the terminal part of the L-motion. Therefore, in the present embodiment, it is possible to cause the disc to move at a sufficiently high speed as compared with the conventional configuration, from the start to the terminal part of the L-motion, and is possible to quickly decelerate the movement speed of the disc to a speed sufficiently low to suppress generation of particles or to suppress an impact, only from the start to the terminal part of the L-motion. Therefore, in the present embodiment, it is possible to significantly shorten the time required for the L-motion of the disc in both the valve closing and the valve opening of the gate valve, as compared with the conventional configuration. As described above, in the present embodiment, by increasing the speed in the timing other than the terminal part of the L-motion and decreasing the speed only in the vicinity of the terminal part, both an increase in the speed in the entire L-motion and prevention of particle generation are achieved.

In the present embodiment, as described above, the L-motion of the disc is composed of movements in the Z direction and the X direction orthogonal thereto (hereinafter, also referred to as "complete L-motion"). In the present invention, the L-motion may be composed of movements in the Z direction and in a direction oblique to the Z direction and the X direction (hereinafter, also referred to as "oblique raising and lowering"). However, in the present embodiment, since the L-motion is the complete L-motion, it is possible to achieve a higher speed than the speed of the L-motion in the oblique raising and lowering, and it is possible to further suppress generation of particles.

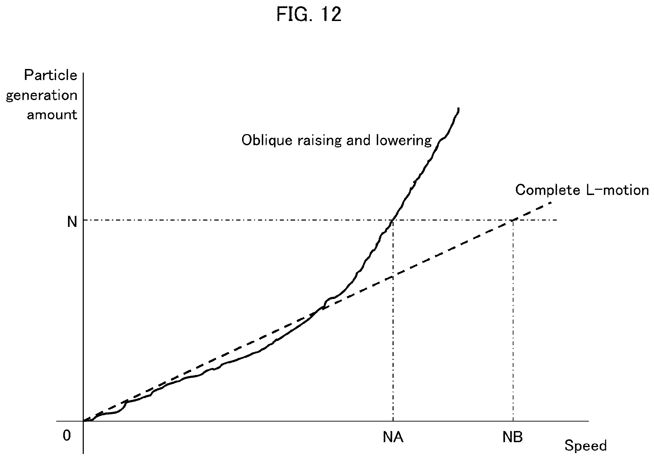

Fig. 12 is a view schematically illustrating a relationship between the speed in the L-motion and a particle generation amount in transitioning to a valve closed state. In the drawing, the vertical axis represents a particle generation amount. The reference sign "N" indicates an allowable value of a particle generation amount, for example, a particle generation amount (threshold) that is allowed in the case of application to the semiconductor manufacturing device as described above. The horizontal axis represents a movement speed in seating of the disc toward the valve seat in transitioning to the valve closed state in the L-motion.

The movement speed of the disc in the X direction (speed of approaching the valve seat) in transitioning to the valve closed state may be faster in the "complete L-motion" than in the "oblique raising and lowering". This is because the ease of generation of particles upon the seating of the disc on the valve seat differs between the "complete L-motion" and the "oblique raising and lowering".

In the complete L-motion, the seal part such as an O-ring and a seal surface on a body side are brought into contact with each other in substantially a perpendicular direction when the disc is seated on the valve seat. Therefore, sliding of the seal part with respect to the seal surface is substantially prevented. In contrast, in the oblique raising and lowering, the seal part slides because the seal part comes into contact with the seal surface obliquely when the disc is seated. The seal part may be scraped by an impact due to the contact and a resistance due to the sliding at the time of seating of the disc, and such scraping causes generation of particles. In this "sliding", the two objects rub each other while causing friction. Therefore, in a manufacturing process for a semiconductor, particles adversely affect the quality of a product such as a wafer, and become one of the causes of a decrease in the yield rate of non-defective products (causes of generation of foreign matters that lead to defective products).

The magnitudes of the impact and sliding are approximately proportional to the speed immediately before the end of the valve closing stroke in the valve. Therefore, in the oblique raising and lowering involving sliding, both the impact and the sliding become larger as the movement speed in the disc seating direction increases, and particles are more likely to be generated. In the complete L-motion in which sliding is substantially prevented, the impact becomes larger as the movement speed in the disc seating direction increases, but since substantially no sliding occurs, generation of particles is suppressed as compared with the oblique raising and lowering. Therefore, between a speed NA at which the allowable value N is reached in the oblique raising and lowering and a speed NB at which the allowable value N is reached in the complete L-motion, the speed NB > the speed NA. As described above, when compared at the same allowable value of the particle generation amount, the complete L-motion makes it possible to increase the movement speed of the disc as compared with the L-motion in the oblique raising and lowering.

### [Main effects]

Typically, in speed control of an air cylinder (pneumatic cylinder), meter-out control using a speed controller or the like is performed. In this case, multi-stage speed control in one stroke by the air cylinder is impossible. In a case where a gate valve is driven to be opened and closed by an air cylinder, a stem is caused to move upward and downward, a disc is caused to move in a horizontal direction at a limit point of the up-and-down movement, and the disc is brought into contact with a seal surface of a body via an O-ring to achieve sealing. At this time, if a horizontal sealing operation is carried out at the same speed as the up-and-down movement of the stem, the disc and the O-ring vigorously come into contact with the body seal surface. Therefore, fine grains called particles may be generated from the body seal surface or the O-ring, and an impact or vibration may be generated at the time of contact. Furthermore, the vigorous contact increases a load on the O-ring, and as a result, a decrease in sealing performance or seal durability performance may be promoted.

In the present embodiment, to achieve the L-motion of the disc of the gate valve with one stroke by the air cylinders, the control section controls the piezoelectric element valves of the flow rate adjustment unit so as to supply air to the air cylinders via the flow rate adjustment unit and to decelerate the disc at the terminal part of the L-motion in transitioning to the valve closed state. The piezoelectric element valves can carry out multiple-stage control and can linearly adjust the flow rate of the air through an electric signal. Therefore, it becomes possible to appropriately change the movement speed of the disc and the stem between the vertical movement and the horizontal direction in the L-motion of the gate valve. Therefore, a trouble due to generation of particles or an impact is prevented. Further, durability of the seal member is also enhanced. Therefore, reliability of the gate valve in the semiconductor manufacturing device is enhanced.

In the present embodiment, more specifically, when the air cylinders reach the terminal part of the valve closing stroke thereby, the control section controls the piezoelectric element valves of the flow rate adjustment unit so as to apply, to the piezoelectric element valves, voltages having values corresponding to flow rates of air (opening degrees of the piezoelectric element valves) for reducing the movement speed of the disc to a desired speed. A control amount of such control is appropriately set in accordance with various conditions such as the type, a stroke, an operating time, and an operating speed of the gate valve, and can be appropriately determined based on a calculated value or a measured value of a movement speed of the disc that causes substantially neither particles, impact, nor vibration in actual use.

In the present embodiment, the piezoelectric element valves of the flow rate adjustment unit can open and close exhaust flow paths from the air cylinders as appropriate. Therefore, it is suitable for quickly achieving deceleration of the L-motion.

In the present embodiment, deceleration at a terminal part of the valve opening stroke is also possible, similarly to the deceleration at the terminal part of the valve closing stroke. Typically, in a mechanical element, a configuration for shock absorption such as an air damper is provided at a terminal end of a stroke movement. In the present embodiment, it is possible to sufficiently reduce an impact at a stroke terminal end by deceleration in a terminal part of the stroke by the air cylinders. Therefore, the present embodiment can eliminate the need for the configuration for shock absorption such as the air damper described above. That is, in the present embodiment, the gate valve can be a gate valve that does not have a shock absorption structure at a position corresponding to the terminal end of the stroke by the air cylinders. Therefore, it is advantageous from the viewpoint of downsizing the gate valve and simplifying the configuration of the gate valve.

In the present embodiment, the two-stage cam structure converts the movement of the disc 46 in the Z direction into the X direction. Therefore, the disc 46 is seated on the valve seat in a state of substantially not being inclined with respect to the valve seat. Therefore, generation of particles or vibration due to, for example, a bias of a load on the sealing material 461 is suppressed, and reliability of the gate valve is further enhanced.

In the present embodiment, an air cylinder is employed as a fluid cylinder, which is a power source for the L-motion. This is advantageous from the viewpoint of procurement and handling of a fluid.

With the semiconductor manufacturing device of the present embodiment, the gate valve above allows for communication and block between the sections corresponding to the processes for semiconductor products, and the gate valve is controlled as described above. In the present embodiment, since generation of an impact or vibration in the gate valve can be prevented, a configuration for preventing an impact or vibration from the gate valve in the semiconductor manufacturing device becomes unnecessary. This further simplifies the configuration of the semiconductor manufacturing device.

Typically, the semiconductor manufacturing device includes a control section for appropriately carrying out a manufacture process. For example, the semiconductor manufacturing device may include a process control section that controls operations of the conveyance section, the processing section, and the gate valve to carry out a process on the wafer. It is also possible to use such a control section of the semiconductor manufacturing device as the control section in the gate valve control mechanism. In this case, it becomes possible to set a speed of opening and closing of the gate valve (a speed in the Z direction and a speed in the X direction in the L-motion) as appropriate in accordance with a process in manufacture of a semiconductor. In this case, the control section in the gate valve control mechanism may be omitted. As described above, in an embodiment of the present invention, a gate valve, as described above, may include a fluid cylinder that seats and separates a disc on and from a valve seat, be configured to cause the disc to move in an L-motion with one stroke by the fluid cylinder, and be configured such that an amount of a fluid in the fluid cylinder is controlled so as to enable deceleration of a movement speed of the disc in a terminal part of the L-motion. Therefore, by applying the gate valve including the flow rate adjustment unit described above to the semiconductor manufacturing device as described above, it is possible to achieve the opening and closing of the disc described in the present embodiment in the gate valve in the semiconductor manufacturing device.

In particular, at an outlet of the semiconductor manufacturing device, after the gate valve is opened and a semiconductor such as a wafer is taken out, the gate valve is closed and gas in a chamber is sucked by vacuuming to keep the inside of the semiconductor manufacturing device clean. The gate valve control mechanism of the present embodiment enables increase in the speed of the opening and closing operation of the gate valve at this time. Therefore, the gate valve control mechanism of the present embodiment can advance a timing of putting a new semiconductor such as a wafer into the chamber from taking out a semiconductor such as a wafer, as compared with the conventional gate valve control mechanism. Therefore, the present embodiment contributes to an improvement in an operating speed of the entire semiconductor manufacturing device. Further, with a linked semiconductor manufacturing device as illustrated in Fig. 1, typically, many semiconductor manufacturing devices are arranged in parallel on the same floor and are in operation. Therefore, applying the gate valve control mechanism of the present embodiment to each semiconductor manufacturing device contributes to a further improvement in the yield in manufacture of a semiconductor.

With the gate valve in the present embodiment, the acceleration and deceleration of the movement speed of the disc can be controlled by the amount of a fluid in the fluid cylinder not only at the terminal part of the L-motion but also at the other timing in the L-motion. Therefore, by controlling as appropriate the movement speed at any position in addition to the terminal part in the L-motion, it becomes possible to achieve various aspects of processing of a wafer in the semiconductor manufacturing device, such as timing of processing in each processing section in the semiconductor manufacturing device or parallel processing in two or more processing sections. Further, the configuration of the semiconductor manufacturing device may be a configuration for achieving such various processing, for example, a conveyance section configured to be capable of conveying wafers to two or more processing sections, or a process control section having a functional configuration for carrying out various processing such as parallel processing, which are configurations having features different from those in the embodiment described above. Therefore, by being applied to a semiconductor manufacturing device, the gate valve of the present embodiment is expected to contribute to achievement of a new aspect of manufacture of a semiconductor or is expected to contribute to an improvement in productivity of a semiconductor product by the new aspect.

### [Variations]

In the present embodiment, the cam grooves 471 and 472 and the cam rollers 511 and 512 may be disposed reversely. Accordingly, the cam rollers may be disposed on a stem 47 side, and the cam grooves may be disposed on a cam follower plate 51 side.

Further, in the present embodiment, a cylinder that uses a fluid other than air, such as a hydraulic cylinder, may be employed instead of the air cylinder 50.

Further, the flow rate adjustment unit 42 in the present embodiment may be configured such that only the air supply flow paths from the flow rate adjustment unit 42 to the air cylinders 50 are opened and closed by the piezoelectric element valves, or may be configured such that only the air exhaust flow paths from the air cylinders 50 to the flow rate adjustment unit 42 can be opened and closed by the piezoelectric element valves. As described above, even if only one of the air supply flow path and the air exhaust flow path can be opened and closed by the pressure element valve, it is possible to sufficiently carry out the control of the movement speed of the disc 46 in the L-motion as described above. The air exhaust flow paths in the former case or the air supply flow paths in the latter case may be constantly opened, or may be opened and closed as appropriate by another valve other than the piezoelectric element valve.

Note that at the time of supplying air to the air cylinder, the flow rate adjustment unit may be configured to be capable of more precisely controlling an amount of air supplied to the air cylinder by further using a piezoelectric element valve that opens and closes the exhaust flow path to control an opening degree of the exhaust flow path. Similarly, at the time of exhausting air from the air cylinder, the flow rate adjustment unit may be configured to be capable of more precisely controlling an amount of air exhausted from the air cylinder by further using a piezoelectric element valve that opens and closes the supply flow path to control an opening degree of the supply flow path.

The gate valve in the present embodiment also encompasses a slit valve and a door valve. A shape of the disc 46 and the opening (slit 441) in the gate valve when viewed in a plan view may not be quadrangular or circular, and is not limited to a specific shape.

In the present embodiment, the two air cylinders are disposed on both sides of the stem, but the number of the air cylinders is not limited. For example, a single air cylinder may be provided alone.

The seal member in the present embodiment may be, for example, an O-ring, but may be another seal material other than an O-ring, such as a resin packing.

The flow rate adjustment unit may be a two-port valve or a three-port valve. Further, in the present embodiment, the polymeric actuator described in Japanese Patent Application, Tokugan, No. 2011-526327 filed by the present applicant can also be used instead of the piezoelectric element valve described above.

### [Software implementation example]

Functions of the control section 43 can be realized by a program for causing a computer to function as the control section 43, the program causing the computer to function as each control block of the control section 43. In this case, the control section 43 includes, as hardware configured to execute the program, a computer that includes at least one controller (e.g., a processor) and at least one storage device (e.g., a memory). By executing the program with the controller and the storage device, the functions described in the above embodiments are realized.

The program can be stored in at least one computer-readable non-transitory storage medium. The storage medium can be provided in the control section 43, or may not be provided in the control section 43. In the latter case, the program can be supplied to the control section 43 via any wired or wireless transmission medium.

Further, some or all of the functions of the control blocks described above can be realized by a logic circuit. For example, an integrated circuit in which a logic circuit that functions as each control block described above is formed is also encompassed in the control section 43. Alternatively, the functions of the control blocks can be realized by, for example, a quantum computer.

Aspects of the present invention can also be expressed as follows:
Aspect 1 of the present invention is a gate valve including a fluid cylinder that seats and separates a disc on and from a valve seat, the gate valve being configured to cause the disc to move in an L-motion with one stroke by the fluid cylinder, an amount of a fluid in the fluid cylinder being controlled so as to enable deceleration of a speed of movement of the disc in a terminal part of the L-motion. According to Aspect 1, it is possible to accelerate opening and closing of the gate valve while preventing generation of particles.

Aspect 2 of the present invention is a gate valve control mechanism (40) including: a gate valve (41) including a fluid cylinder (air cylinder 50) that seats and separates a disc (46) on and from a valve seat, the gate valve being configured to cause the disc to move in an L-motion with one stroke by the fluid cylinder; a piezoelectric element valve (64-67) or polymeric actuator that controls an amount of a fluid in the fluid cylinder by opening and closing one or both of a supply flow path of a fluid to the fluid cylinder and a discharge flow path of a fluid from the fluid cylinder through application of a voltage; and a control section (43) that controls a voltage applied to the piezoelectric element valve or the polymeric actuator so as to reduce an amount of the fluid in the fluid cylinder at least in a terminal part of a valve closing stroke by the fluid cylinder for seating the disc on the valve seat. According to Aspect 2, it is possible to accelerate opening and closing of the gate valve while preventing generation of particles.

In Aspect 3 of the present invention, in Aspect 2, the control section controls the voltage applied to the piezoelectric element valve or the polymeric actuator so as to reduce an amount of the fluid in the fluid cylinder also in a terminal part of a valve opening stroke by the fluid cylinder for separating the disc from the valve seat. Aspect 3 is further advantageous from the viewpoint of reducing vibration or impact in the gate valve in transitioning to a valve open state and from the viewpoint of downsizing the gate valve and simplifying the configuration of the gate valve.

In Aspect 4 of the present invention, in Aspect 2 or 3, the gate valve includes: a stem (47) supporting the disc and movable in a stroke direction and in directions closer to and away from the valve seat in coordination with a stroke by the fluid cylinder; a coordination section that causes the stem to move in coordination with a stroke by the fluid cylinder; cam rollers (511, 512) supported by one of the stem and the coordination section and engaging with the other one of the stem and the coordination section; and cam grooves (471, 472) which are formed in the other one of the stem and the coordination section, with which the cam rollers engage, and in which the cam rollers are slidable. In addition, the cam rollers and the cam grooves are both disposed in two locations in a stroke by the fluid cylinder, either the cam rollers or the cam grooves are disposed obliquely so as to be located farther away from the valve seat toward a terminal end of the valve closing stroke, and the coordination section causes, from start to the terminal part of the valve closing stroke, the stem to move in coordination with a stroke by the fluid cylinder in a direction of the valve closing stroke by the fluid cylinder, and causes, from the terminal part to the terminal end of the valve closing stroke, the stem to move in coordination with a stroke by the fluid cylinder in a direction crossing the valve closing stroke by the fluid cylinder. Aspect 4 is further advantageous from the viewpoint of preventing occurrence of problems with the gate valve caused by contact of the disc with the valve seat and improving reliability of the gate valve.

In Aspect 5 of the present invention, in any one of Aspects 2 to 4, the fluid cylinder is an air cylinder, and the fluid is air. Aspect 5 is further advantageous from the viewpoint of easily procuring a fluid in the fluid cylinder and facilitating handling of the fluid.

Aspect 6 of the present invention is a method for controlling the gate valve control mechanism according to any one of Aspects 2 to 5, the method including controlling a voltage applied to the piezoelectric element valve or polymeric actuator so as to reduce an amount of the fluid in the fluid cylinder when the fluid cylinder has reached at least the terminal part of the valve closing stroke by the fluid cylinder. According to Aspect 6, it is possible to accelerate opening and closing of the gate valve while preventing generation of particles, as in the case of Aspect 2.

In Aspect 7 of the present invention, in Aspect 6, when the fluid cylinder has reached the terminal part of the valve closing stroke by the fluid cylinder, a voltage having a value that corresponds to an amount of the fluid in the fluid cylinder for reducing a speed of movement of the disc with the valve closing stroke by the fluid cylinder to a set speed is applied to the piezoelectric element valve or the polymeric actuator. Aspect 7 is further advantageous from the viewpoint of exerting the above-described effect according to the conditions of the gate valve in actual use.

In Aspect 8 of the present invention, in Aspect 6 or 7, when the fluid cylinder has reached the terminal part of the valve opening stroke by the fluid cylinder, a voltage having a value that corresponds to an amount of the fluid in the fluid cylinder for reducing a speed of movement of the disc by the valve opening stroke by the fluid cylinder to a set speed is applied to the piezoelectric element valve or the polymeric actuator. Aspect 8 is further advantageous from the viewpoint of reducing vibration or impact in the gate valve in transitioning to a valve open state and from the viewpoint of downsizing the gate valve and simplifying the configuration of the gate valve.

Aspect 9 of the present invention is a semiconductor manufacturing device including: a conveyance section (10) that conveys a wafer for a semiconductor product; a processing section (20) that processes the wafer conveyed from the conveyance section; a gate valve that allows for communication and block between the conveyance section and the processing section; and a process control section that controls operations of the conveyance section, the processing section, and the gate valve to carry out a process on the wafer, the gate valve including a fluid cylinder that seats and separates a disc on and from a valve seat, the gate valve being configured to cause the disc to move in an L-motion with one stroke by the fluid cylinder, an amount of a fluid in the fluid cylinder being controlled so as to enable deceleration of a speed of movement of the disc at least in a terminal part of the L-motion. According to Aspect 9, it is possible to accelerate opening and closing of the gate valve in the semiconductor manufacturing device while preventing generation of particles, and further improve reliability of a manufacturing device and yield of a semiconductor product in manufacture of a semiconductor.

In Aspect 10 of the present invention, in Aspects 2 to 5, the piezoelectric element valve or polymeric actuator opens and closes the discharge flow path through application of a voltage. Aspect 10 is further advantageous from the viewpoint of quickly achieving deceleration of the disc in the stroke terminal part.

According to the present embodiment, simplification of and improvement in reliability of a gate valve in manufacture of a semiconductor are expected. The present embodiment that exerts such an effect is expected to contribute to achievement of, for example, Goal 9 "Build resilient infrastructure, promote inclusive and sustainable industrialization and foster innovation" of Sustainable Development Goals (SDGs) proposed by the United Nations.

The present invention is not limited to the embodiments, but can be altered by a skilled person in the art within the scope of the claims. The present invention also encompasses, in its technical scope, any embodiment derived by combining technical means disclosed in differing embodiments as appropriate.

### Reference Signs List

1 Semiconductor manufacturing device
10 Conveyance section
11 Conveyance table
12 Rail
20 Processing section
30 Accommodation section
40 Gate valve control mechanism
41 Gate valve
42 Flow rate adjustment unit
43 Control section
44 Body
45 Drive section
46 Disc
47 Stem
48 Spring
49 Base plate
50 Air cylinder
51 Cam follower plate
61 Supply chamber
62, 63 Communication chamber
64, 65 First piezoelectric element valve
66, 67 Second piezoelectric element valve
100 Wafer
441 Slit
451 Roller block
452, 453 Nozzle
461 Seal part
471, 472 Cam groove
473 Substrate
501 Cylinder tube
502 Piston rod
503 First chamber
504 Second chamber
511, 512 Cam roller
611 Supply opening
612, 613 Communication opening
621, 631 Ventilation opening
622, 632 Exhaust opening

## Claims

1. A gate valve comprising a fluid cylinder that seats and separates a disc on and from a valve seat, the gate valve being configured to cause the disc to move in an L-motion with one stroke by the fluid cylinder, wherein
an amount of a fluid in the fluid cylinder is controlled so as to enable deceleration of a speed of movement of the disc at least in a terminal part of the L-motion.

2. A gate valve control mechanism comprising:
a gate valve including a fluid cylinder that seats and separates a disc on and from a valve seat, the gate valve being configured to cause the disc to move in an L-motion with one stroke by the fluid cylinder;
a piezoelectric element valve or a polymeric actuator that controls an amount of a fluid in the fluid cylinder by opening and closing one or both of a supply flow path of a fluid to the fluid cylinder and a discharge flow path of a fluid from the fluid cylinder through application of a voltage; and
a control section that controls a voltage applied to the piezoelectric element valve or the polymeric actuator so as to reduce an amount of the fluid in the fluid cylinder at least in a terminal part of a valve closing stroke by the fluid cylinder for seating the disc on the valve seat.

3. The gate valve control mechanism according to claim 2, wherein the control section controls the voltage applied to the piezoelectric element valve or the polymeric actuator so as to reduce an amount of the fluid in the fluid cylinder also in a terminal part of a valve opening stroke by the fluid cylinder for separating the disc from the valve seat.

4. The gate valve control mechanism according to claim 2, wherein the gate valve includes:
a stem supporting the disc and movable in a stroke direction and in directions closer to and away from the valve seat in coordination with a stroke by the fluid cylinder;
a coordination section that causes the stem to move in coordination with a stroke by the fluid cylinder;
cam rollers supported by one of the stem and the coordination section and engaging with the other one of the stem and the coordination section; and
cam grooves which are formed in the other one of the stem and the coordination section, with which the cam rollers engage, and in which the cam rollers are slidable, wherein
the cam rollers and the cam grooves are both disposed in two locations in a stroke by the fluid cylinder,
either the cam rollers or the cam grooves are disposed obliquely so as to be located farther away from the valve seat toward a terminal end of the valve closing stroke, and
the coordination section causes, from start to the terminal part of the valve closing stroke, the stem to move in coordination with a stroke by the fluid cylinder in a direction of the valve closing stroke by the fluid cylinder, and causes, from the terminal part to the terminal end of the valve closing stroke, the stem to move in coordination with a stroke by the fluid cylinder in a direction crossing the valve closing stroke by the fluid cylinder.

5. The gate valve control mechanism according to claim 2, wherein the fluid cylinder is an air cylinder, and the fluid is air.

6. A method for controlling the gate valve control mechanism according to any one of claims 2 to 5, the method comprising
controlling a voltage applied to the piezoelectric element valve or the polymeric actuator so as to reduce an amount of the fluid in the fluid cylinder when the fluid cylinder has reached at least the terminal part of the valve closing stroke by the fluid cylinder.

7. The method according to claim 6, wherein when the fluid cylinder has reached the terminal part of the valve closing stroke by the fluid cylinder, a voltage having a value that corresponds to an amount of the fluid in the fluid cylinder for reducing a speed of movement of the disc with the valve closing stroke by the fluid cylinder to a set speed is applied to the piezoelectric element valve or the polymeric actuator.

8. The method according to claim 6, wherein when the fluid cylinder has reached the terminal part of the valve opening stroke by the fluid cylinder, a voltage having a value that corresponds to an amount of the fluid in the fluid cylinder for reducing a speed of movement of the disc by the valve opening stroke by the fluid cylinder to a set speed is applied to the piezoelectric element valve or the polymeric actuator.

9. A semiconductor manufacturing device comprising:
a conveyance section that conveys a wafer for a semiconductor product;
a processing section that processes the wafer conveyed from the conveyance section;
a gate valve that allows for communication and block between the conveyance section and the processing section; and
a process control section that controls operations of the conveyance section, the processing section, and the gate valve to carry out a process on the wafer, wherein
the gate valve includes a fluid cylinder that seats and separates a disc on and from a valve seat, the gate valve being configured to cause the disc to move in an L-motion with one stroke by the fluid cylinder, and
an amount of a fluid in the fluid cylinder is controlled so as to enable deceleration of a speed of movement of the disc at least in a terminal part of the L-motion.
